# EUROPEAN PATENT SPECIFICATION

(11) **EP 2 017 890 B1**
(45) Date of publication and mention of the grant of the patent: **07.10.2015**
(21) Application number: 07405164.0
(22) Date of filing: 07.06.2007
(51) Int. Cl.: H01L 25/075, H05B 33/08, H01L 25/16, H01L 33/50

(54) **White-light LED-based device**
Weißlicht LED-basierte Vorrichtung
Dispositif émetteur de lumière blanche à base de DELs

(43) Date of publication of application: 21.01.2009
(73) Proprietor: CFG S.A., 1110 Morges (CH)
(72) Inventor: Frauenknecht, Jean Marc, 1030 Bussigny-près-Lausanne (CH); Cohen, Marc, 1006 Lausanne (CH)
(74) Representative: Reuteler, Raymond Werner

(56) References cited:
- EP-A1- 1 557 890
- WO-A-2005/022030
- WO-A-2007/060595
- US-A1- 2003 043 107
- US-A1- 2004 026 683
- US-A1- 2004 256 626
- US-A1- 2006 012 986
- US-A1- 2006 197 098
- US-B1- 7 002 546

## Description

The present invention relates to a LED lighting device for generating white light.

There are various known means of generating white light from light emitting diodes (LEDs). Many known systems employ a single diode emitting blue light, surrounded by a phosphorescent substance that absorbs some of the blue light emitted by the LED and re-emits it at another frequency such that the combination of the blue light emitted by the LED and light diffused by the phosphorescent material produces essentially white light.

Other known systems, described for example in WO 2005/022030 A2 employ two diodes emitting respectively blue and green, together with a red-emitting phosphor to produce white light.

It is also known to use two or more LEDs generating light at different wave lengths that combine to produce essentially white light.

It is further known, for example from US 2004/0256626 A1 or US 2006/0197098 A1, to use two LEDs emitting respectively blue and green, together with two phosphors emitting respectively yellow and red to produce white light.

Blue diodes are significantly more expensive to produce than diodes that generate green or red, or green-yellow light. Moreover, the quality of white light from single diode LEDs is more costly or difficult to control than in multiple diode white light devices due to the larger variations in intensity and wave length in blue diodes (compared to other colour diodes) and the dependence on the properties of the phosphorescent substance. As a result, single diode white-lights LEDs are often delivered in different white colour ranges or CIE1931 coordinates. There is also a problem of a shift in the intensity and wavelength of single diode white LEDs as they age.

White light LEDs based on three diodes are known, however they are also relatively costly to produce and the LED takes more surface area and therefore decreases the number of light pixels that may be mounted on a certain surface area.

It is also known to produce white light LEDs based on two diodes, a blue diode and a green-yellow diode as for example described in EP 1 557 890 A1. While such diodes overcome the problems associated with single diodes and allow easier calibration to generate essentially white light within certain tolerances, the energy efficiency of such diodes is not optimal. In combining blue and yellow-green light to produce white light, only around 20% of the blue light intensity is needed compared to the green-yellow light intensity leading to a loss of efficiency and unused potential from the blue light diode. The blue light diode which is the more expensive of the two is thus used inefficiently.

Another disadvantage of known multi-diode LEDs is that they are packaged as units in a housing that is voluminous in comparison to the semiconductor chips forming the diodes, thus leading to a relatively low pixel density when mounted on a support with a plurality of other LEDs.

Conventional white light LEDs also suffer from a shift in colour as the device ages. Moreover, in two diode LEDs the range of tolerances in colour and intensity may be quite high such that achieving white light close to a set specification is difficult and costly.

In view of the aforegoing, it is an object of this invention to provide an accurate white light LED device that is economical to produce.

It is a further object of this invention to provide a white light LED device that corrects for colour shifts due to aging and/or temperature change.

It would be advantageous to provide a white light LED that is economical, yet performant and compact such that a high density of white light pixels per surface area may be provided, or that more flexibility in pixel positioning for various applications is possible.

The objects of this invention have been achieved by providing a white light LED device in accordance with the appended claim 1.

Advantageously, the pigment enables efficient use of the energy from the blue light and reduces the possible spread of colours (i.e. tolerances in colour variation) of the LED device around the specified white chromaticity value. Moreover, the LED device according to the invention benefits from the ease of control of the combination of two diodes for generating white light within a certain colour tolerance range by adjustment of the respective intensities of the two diodes.

The pigment substance comprises a pigment with a dominant absorption spectrum in the range of 430 nm to 500 nm, preferably with a minimal absorption in the range of 550 nm to 590 nm in order to avoid or minimise absorption of the photons emitted by the second diode, and a dominant emission spectrum in the range of 590 nm to 610 nm.

The diodes may advantageously be mounted directly on a circuit board by known Chip on Board (COB) mounting and wire bonding techniques, the two diodes being mounted one next to the other on the board and encapsulated in the pigment containing substance.

The blue, first diode with a dominant wavelength between 470 nm to 475 nm is preferably an InGaN/SiC diode. The second diode is preferably a yellow-green diode, of preferably AlGalnP/GaAs, with a dominant wavelength in the range of 570 nm to 576 nm. Such diodes per se are available in mass production and are thus cost effective and have well-understood and predictable parameters.

According to an advantageous feature of the invention, each diode is preferably independently driven by means of a pulse width modulation (PWM) controller at constant current amplitude. Preferably the frequency of the PWM signal is greater than 1 kHz in order to avoid any perception of flickering to the observer. Since the wavelength of LEDs may vary as a function of the direct current level, the aforementioned method of controlling the light intensity of the LEDs reduces colour shift of the LEDs when changing intensity.

According to another advantageous feature of the invention, the effects of colour shift due to aging may be compensated for by providing a reference LED device comprising a pair of first and second diodes encapsulated in the pigment containing substance and mounted on a circuit board or support, further comprising a photodetector mounted on the circuit board or support in proximity to the first and second diodes, and a reflective layer mounted on the pigment containing substance over the first and second diodes. The photodetector is configured to receive light emitted from the diodes reflected off the reflective layer.

The photodetector may be connected in a feedback loop to the control circuit controlling the other LEDs mounted on the circuit board, to correct any shift in colour.

The first and second diodes and the pigment containing substance of the reference device preferably belong to the same manufacturing batch as the other LEDs on the circuit board. As the reference LED device is subject to essentially the same operating and environmental conditions as the other LEDs, any colour shift experienced due to aging therein forms a good proxy for the colour shift experienced by other LEDs and thus enables correction of the emitted white chromaticity value by varying the relative intensity of the first and second diodes.

Further objects and advantageous aspects of the invention will be apparent from the claims and the following detailed description of embodiments of the invention with reference to the figures in which:
- Figure 1 is a chromaticity diagram according to the standard CIE1931 on which lines interpolating between the dominant wavelength values of the two diodes are depicted;
- Figure 2 is a graph to illustrate a simplified pulse width modulation signal;
- Figure 3 is a simplified cross-sectional view of a white light LED device according to this invention;
- Figure 4 is a cross-sectional view through a reference white light LED device for calibrating white light LED devices according to this invention.

Referring to the figures, a white light LED device according to this invention comprises a first diode 2 and a second diode 4 mounted on a circuit board or other support 6 and connected to a power supply and control circuit (not shown) by means of electrical connections 8 that may for example be wires interconnecting the diodes to conductive traces on the circuit board 6. The first diode 2 generates light in the blue colour range comprised between 470 and 475 nm. Such blue colour range diodes are per se known and are produced for example from semi-conductors of the type InGaN/SiC with a dominant wavelength in the range of 470 to 475 nm.

The second diode 4 generates light in the green-yellow colour range with a dominant wavelength in the range of 570 to 576 nm. Such diodes per se are well-known and may be made from semiconductors of the type AlGalnP/GaAs with a dominant wavelength in the range of 570 to 576 nm.

The diodes and connection terminals 8 may advantageously be mounted on the circuit board 6 by conventional Chip on Board manufacturing techniques with wire bonding of the semiconductor to circuit traces. This enables a high density of LEDs to be mounted on a circuit board for various applications, for example for use as lighting on automotive dashboard components, for backlighting of screens or panels, for displays in a multitude of applications or portable lighting apparatuses.

The pair of diodes 2, 4 are encapsulated in a pigment containing substance 10, the pigment containing substance 10 comprises a pigment with a dominant absorption spectrum in the range of 430 nm to 500 nm preferably with a minimal absorption in the range of 550 nm to 590 nm in order to avoid or minimise absorption of the photons emitted by the second diode, and a dominant emission spectrum in the range of 590 nm to 610 nm pigment absorbs thus some of the blue light emitted by the first diode 2 and converts it to a light in the orange or yellow colour range such that the overall mix of remaining blue light, orange or yellow light and green-yellow light combines to form white light. Various above defined pigments may be used to the extent that they generate by photoluminescence light in the above defined orange or yellow colour range by absorbing essentially blue light.

An example of a pigment that may be used in the invention is the pigment FLAME ORANGE HMP-4 supplied by the firm CHIMIRAY of F-92502 Rueil Malmaison, France, and manufactured by the firm SWADA (LONDON) Ltd of Great Britain. The pigment containing substance further comprises a resin, polymer or other essentially translucent or transparent compound that acts as a carrier for the pigment, in which the pigment is mixed or dissolved and that can be deposited in gel or liquid form on the diodes and subsequently hardened. Examples of suitable resins or polymers are one- or two-part silicone heat cure gels (for example Dow Corning JCR 6109 or JCR 6110), elastomers (for example Dow Corning JCR 6101 or JCR 6122) or resins (for example Dow Corning SR-7010). The dispensing methods may be by syringe and/or precision molding. Certain resins require heat curing for hardening but some may be cured at room temperature.

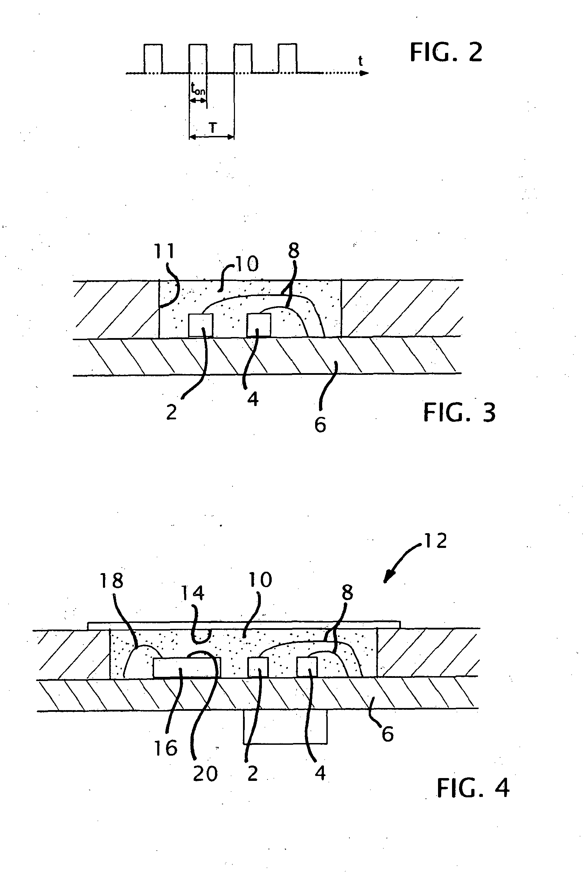

In the embodiment of figure 3, the diodes 2, 4 are illustrated as being provided in a well 11 in which the pigment containing substance 10 is deposited, however the pigment containing substance may also be deposited as a droplet on the diodes 2, 4 without a cavity around the diodes. Because of the surface tension of the liquid droplet during the depositing procedure, the droplet forms a convex surface around the diodes.

The direct Chip on Board mounting of the diodes enables the diodes to be positioned in a wide variety of configurations and shapes on the surface of a circuit board in a very precise and/or compact arrangement.

The intensity and wavelength of light produced by the diodes vary reversibly as a function of temperature, and irreversibly as the device ages. Colour shift due to temperature variations may be empirically determined and compensated for by the LED control circuit, whereby a temperature sensor may be positioned on the circuit board to provide the temperature reading necessary for compensation.

In order to correct the intensities of the two diodes in order to compensate for age related colour shift, a reference LED device 12, as shown in figure 4, may advantageously be mounted on the circuit board or support on which the white light LEDs are mounted.

The reference LED device 12 comprises first and second diodes 2, 4 encapsulated in the pigment containing substance 10, essentially identical to the diodes and substance of the LED device described in relation to Figure 3. They are preferably from the same manufacturing batch as the diodes of the other LEDs on the circuit board in order to simulate as closely as possible the variations in colour shift of the lighting LEDs. The reference LED however further comprises a reflective or partially reflective layer 14 covering the pigment containing substance 10, and a photodetector 16 mounted on the circuit board 6 and connected via a connection 18 to circuit traces on the circuit board, the photodetector being encapsulated by the pigment containing substance. The photodetector 16 has a photosensitive detecting surface 20 that captures light emitted from the diodes 2, 4 that reflects off the reflective layer 14. Colour shifts due to irreversible or reversible factors, whether aging or temperature related, will effect the reference LED in a similar manner to the other LEDs on the same circuit board and will be detected by the photodetector 16 which is connected in a feedback loop to the LED control circuit (not shown) to correct for any colour shift.

Colour shift correction is performed by adjusting the relative intensity of the first diode with respect to the second diode. The intensity of the LED device is adjusted by adjusting the absolute intensity (power) of both diodes.

The photodetector may for example comprise a PIN diode and the control circuit may advantageously comprise a microprocessor mounted on the circuit board. The microprocessor, photodetector and LEDs may be mounted on the circuit board by essentially the same Chip on Board assembly techniques.

Each diode may advantageously be independently controlled by a PWM (pulse width modulation) signal having a pulse width tₒₙ and period T (see Figure 2) at substantially constant current (signal amplitude). The frequency of the signal is preferably in the range of 1 to 2 kHz or more in order to ensure that the oscillation is not perceived by the observer. The intensity of the diode is controlled by varying the ratio tₒₙ/T of the PWM signal. This means varying the pulse width and/or frequency of the signal.

An important advantage of this control method is a reduction in variation in the dominant wavelength of the diode due to a variation in current intensity. Pulse width modulation may also be more accurately controlled than current intensity variation.

The separate PWM signal to each diode thus enables very accurate control of the light intensities of each diode in the absolute and relative sense. Accurate adjustment and correction of the colour of the light emitted by the LEDs may thus be achieved.

The light intensity relationship between two diodes may be expressed with the following relationship Kᵢₗ = tₒₙ₁ x Iᵣₑₗ₁/(tₒₙ₂ x Iᵣₑₗ₂) where Iᵣₑₗ₁ and Iᵣₑₗ₂ represent the optical efficiency factors of the first and second diodes respectively in Im/watt. The obtention of a white light according to a specification K_{il-white} is achieved by varying the pulse widths tₒₙ₁ and tₒₙ₂ of the two diodes.

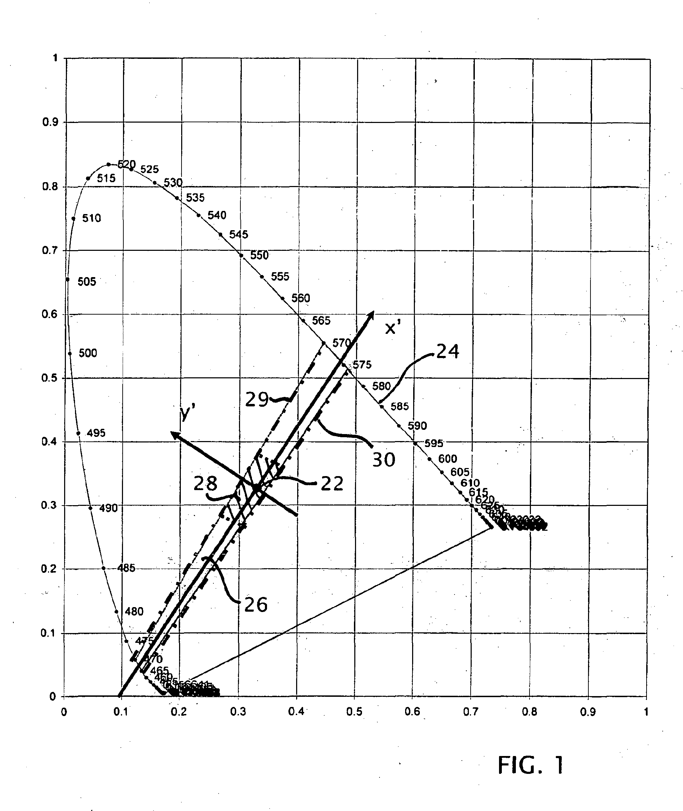

As can be seen in Figure 1, which illustrates a chromaticity diagram according to standard CIE1931, pure white light is considered to be at the point referenced 22 within the graph, with coordinates (x, y) = approximately (0.33, 0.33). The first and second diodes are selected such that the wavelength of their dominant light emission are at diametrically opposed positions with respect to the "pure" white point 22 on the chromaticity curve 24. In view of the tolerances and spread in possible wavelengths, the possible range of colours produced by the pair of diodes is found within a band 26 bounded by the curve 24 and upper and lower limits corresponding to an upper green bias limit 29 and a lower red bias limit 30. The variation of the colour within the band along the *x*' axis is adjusted by varying the relative intensity of the two diodes whereas the tolerance along the *y*' axis is improved by reducing the spread in values the dominant wavelength of the first and second diodes. This may be obtained by measuring the spectrum of the emitted light from a diode on a semiconductor wafer during the manufacturing process. The tolerances between diodes of the same wafer are very small thus enabling batch testing.

The pigment containing substance advantageously has the effect of narrowing the colour spectrum variation around the pure white point 22, as illustrated by the hatched surface area 28. This is because the pigment absorbs some of the blue light of the first diode and converts it to light in an orange or yellow range of colours. Besides reducing the possible spectrum deviation from pure white, the pigment containing substance also has the important advantage of enabling the blue diode to be used at an optimal or close to optimal intensity thus increasing overall light intensity of the LED and efficiency.

## Claims

1. A white light LED device comprising a first diode (2) generating light at a first dominant wavelength in a blue colour range and a second diode (4) generating light at a second dominant wavelength in a green-yellow colour range, wherein the device further comprises a colour pigment substance (10) surrounding at least the first diode, configured to convert by photoluminescence some of the energy emitted by the first diode into light in an orange or yellow colour range, wherein the first diode has a dominant wavelength between 470 nm to 475 nm and the second diode has a dominant wavelength in the range of 570 nm to 576 nm, and wherein the pigment substance comprises a pigment with a dominant absorption spectrum in the range of 430 nm to 500 nm and a dominant emission spectrum in the range of 590 nm to 610 nm.

2. LED device according to claim 1 wherein the diodes are mounted directly on a circuit board (6) by Chip on Board (COB) mounting and wire bonding technique.

3. LED device according to any one of the preceding claims, wherein the first diode is an InGaN/SiC diode and the second diode is a AlGaInP/GaAs diode.

4. LED device according to any one of the preceding claims wherein each diode is independently driven by means of a pulse width modulation (PWM) controller.

5. LED device according to claim 4 wherein the diodes are driven at constant current amplitude.

6. LED device according to claim 4 or 5 wherein the frequency of the PWM signal is greater than 1 kHz.

7. LED device according to any one of the preceding claims further comprising a reference LED device (12) comprising a pair of first and second diodes (2, 4) encapsulated in the pigment containing substance (10) and mounted on the circuit board (6) or support, and a photodetector (16) mounted on the circuit board or support in proximity to the first and second diodes.

8. LED device according to claim 7 wherein the reference LED device comprises a reflective layer (14) mounted over the pigment containing substance and first and second diodes.

9. LED device according to claim 7 or 8 wherein the photodetector is connected in a feedback loop to a control circuit controlling white light LEDs mounted on the circuit board, configured to correct a shift in colour.

## Patentansprüche

1. Weißlicht-LED-Vorrichtung, aufweisend eine erste Diode (2), die Licht bei einer ersten dominanten Wellenlänge in einem blauen Farbbereich erzeugt, und eine zweite Diode (4), die Licht bei einer zweiten dominanten Wellenlänge in einem grün-gelben Farbbereich erzeugt, wobei die Vorrichtung ferner eine mindestens die erste Diode umgebende Farbpigmentsubstanz (10) aufweist, die konfiguriert ist für ein Umwandeln durch Photolumineszenz eines Teils der von der ersten Diode emittierten Energie in Licht in einem orange oder gelben Farbbereich, wobei die erste Diode eine dominante Wellenlänge zwischen 470 nm und 475 nm und die zweite Diode eine dominante Wellenlänge im Bereich von 570 nm bis 576 nm aufweist, und wobei die Pigmentsubstanz ein Pigment mit einem dominanten Absorptionsspektrum im Bereich von 430 nm bis 500 nm und ein dominantes Emissionsspektrum im Bereich von 590 nm bis 610 nm aufweist.

2. LED-Vorrichtung nach Anspruch 1, wobei die Dioden direkt auf einer Leiterplatte (6) durch Chip-on-Board-Technologie (COB) und Drahtbonding-Technik montiert sind.

3. LED-Vorrichtung nach einem der vorhergehenden Ansprüche, wobei die erste Diode eine InGaN/SiC-Diode und die zweite Diode eine AlGaInP/GaAs- Diode ist.

4. LED-Vorrichtung nach einem der vorhergehenden Ansprüche, wobei jede Diode unabhängig mithilfe einer Pulsweitenmodulations-(PWM-)-Steuerung angesteuert wird.

5. LED-Vorrichtung nach Anspruch 4, wobei die Dioden mit konstanter Stromamplitude angesteuert werden.

6. LED-Vorrichtung nach Anspruch 4 oder 5, wobei die Frequenz der PWM größer ist als 1 kHz.

7. LED-Vorrichtung nach einem der vorhergehenden Ansprüche, ferner aufweisend eine Referenz-LED-Vorrichtung (12), aufweisend ein Paar erster und zweiter Dioden (2, 4), die in der Pigment enthaltenden Substanz (10) eingekapselt und auf der Leiterplatte (6) oder einer Stütze montiert sind, und einen Photodetektor (16), der auf der Leiterplatte oder einer Stütze in der Nähe der ersten und zweiten Dioden montiert ist.

8. LED-Vorrichtung nach Anspruch 7, wobei die Referenz-LED-Vorrichtung eine Reflexionsschicht (14) aufweist, die über der Pigment enthaltenden Substanz und den ersten und zweiten Dioden montiert ist.

9. LED-Vorrichtung nach Anspruch 7 oder 8, wobei der Photodetektor in einer Rückkopplungsschleife mit einer Steuerschaltung verbunden ist, die auf der Leiterplatte montierte Weißlicht-LED steuert, die konfiguriert ist zum Korrigieren einer Farbverschiebung.

## Revendications

1. Dispositif à DEL à lumière blanche comprenant une première diode (2) générant une lumière à une première longueur d'onde dominante dans une plage de couleur bleue et une deuxième diode (4) générant une lumière à une deuxième longueur d'onde dominante dans une plage de couleur verte-jaune, dans lequel le dispositif comprend en outre une substance contenant un pigment de couleur (10) entourant au moins la première diode, configurée pour convertir par photoluminescence une partie de l'énergie émise par la première diode en une lumière dans une plage de couleur orange ou jaune, dans lequel la première diode a une longueur d'onde dominante entre 470 nm et 475 nm et la deuxième diode a une longueur d'onde dominante dans la plage de 570 nm à 576 nm, et dans lequel la substance contenant un pigment comprend un pigment avec un spectre d'absorption dominant dans la plage de 430 nm à 500 nm et un spectre d'émission dominant dans la plage de 590 nm à 610 nm.

2. Dispositif à DEL selon la revendication 1, dans lequel les diodes sont montées directement sur une carte de circuit (6) par une technique de montage COB (Chip on Board) et de liaison par fils.

3. Dispositif à DEL selon l'une quelconque des revendications précédentes, dans lequel la première diode est une diode en InGaN/SiC et la deuxième diode est une diode en AlGaInP/GaAs.

4. Dispositif à DEL selon l'une quelconque des revendications précédentes, dans lequel chaque diode est commandée de manière indépendante au moyen d'un contrôleur de modulation de durée d'impulsion (PWM).

5. Dispositif à DEL selon la revendication 4, dans lequel les diodes sont commandées avec une amplitude de courant constante.

6. Dispositif à DEL selon la revendication 4 ou 5, dans lequel la fréquence du signal de PWM est supérieure à 1 kHz.

7. Dispositif à DEL selon l'une quelconque des revendications précédentes, comprenant en outre un dispositif à DEL de référence (12) comprenant une paire de première et deuxième diodes (2, 4) encapsulées dans la substance contenant un pigment (10) et montées sur la carte de circuit (6) ou le support, et un photodétecteur (16) monté sur la carte de circuit ou le support à proximité des première et deuxième diodes.

8. Dispositif à DEL selon la revendication 7, dans lequel le dispositif à DEL de référence comprend une couche de réflexion (14) montée sur la substance contenant un pigment et des première et deuxième diodes.

9. Dispositif à DEL selon la revendication 7 ou 8, dans lequel le photodétecteur est connecté dans une boucle de rétroaction à un circuit de commande commandant les DEL à lumière blanche montées sur la carte de circuit, configuré pour corriger un décalage de couleur.
